Europäisches Patentamt

European Patent Office

Office européen des brevets

(11) Publication number: **0 081 818**
**B1**

## (12) EUROPEAN PATENT SPECIFICATION

(45) Date of publication of patent specification: **09.05.90**

(21) Application number: **82111430.3**

(22) Date of filing: **09.12.82**

(51) Int. Cl.⁵: **H 03 D 9/06**

(54) Microwave integrated circuit frequency converter.

(30) Priority: **11.12.81 JP 200511/81**

(43) Date of publication of application:
**22.06.83 Bulletin 83/25**

(45) Publication of the grant of the patent:
**09.05.90 Bulletin 90/19**

(84) Designated Contracting States:
**DE FR GB**

(56) References cited:
**EP-A-0 068 870**
**DE-A-2 706 373**
**DE-A-2 921 790**
**US-A-3 659 206**

**IEEE TRANSACTIONS ON CONSUMER**
**ELECTRONICS, vol. CE-26, no. 1, February 1980,**
**pages 1-7, New York, USA**

(73) Proprietor: **NEC CORPORATION**
**33-1, Shiba 5-chome, Minato-ku**
**Tokyo 108 (JP)**

(72) Inventor: **Ishihara, Hiroyuki**
**c/o NEC CORPORATION, 33-1, Shiba 5-chome**
**Minato-ku, Tokyo 108 (JP)**

(74) Representative: **Vossius & Partner**
**Siebertstrasse 4 P.O. Box 86 07 67**
**D-8000 München 86 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Background of the invention

The present invention relates to a microwave integrated circuit (MIC) frequency converter and, more particularly, to an image reflection type MIC frequency, converter which is low in conversion loss and excellent in frequency characteristics.

In a prior art frequency converter or mixer of the type described, an input signal is fed through a bandpass filter and a transmission line having a predetermined electrical length to a junction. A local oscillator signal is fed through a similar bandpass filter and transmission line to the junction. A diode which is short-circuited at one end is connected at its other end to the junction. The junction is also connected through a low pass filter to an output terminal at which the output in the form of an intermediate frequency appears.

In this type of converter, since the signal and local oscillator impedances are matched to the diode by the transmission lines, for the signal and local frequencies, respectively, it is difficult or impossible to optimally terminate an image frequency in such a manner as to provide minimum conversion loss.

In another prior art frequency converter, signal and local oscillator bandstop filters are substituted for the bandpass filters and a bandstop filter is used to provide a short-circuit impedance to the image frequency. However, it is difficult to achieve good performance with a circuit size when the input signal has a relatively wide bandwidth. In the frequency converter having a wide signal bandwidth, the multi-resonator bandstop filters for the signal and image frequencies are necessitated to obtain a wide stop band. This results in an increase in the circuit size and a need of forming impracticably narrow coupling gaps between the input microstrip lines and resonators.

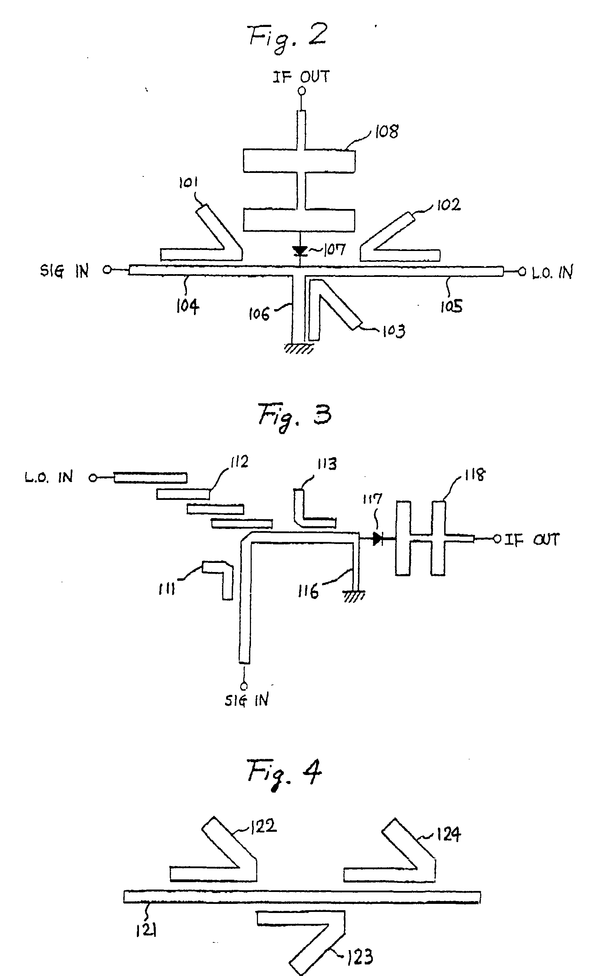

The US—A—4,211,977 describes a microwave mixer circuit according to the preamble of claim 1. This known circuit shown in the attached Fig. 2, however, is still undesirously spacious and can only be used in case of a relatively narrow bandwidth.

It is an object of the present invention to provide a generally improved microwave integrated circuit frequency converter with broad bandwidth compared to the prior art frequency converters.

This object is solved by the features recited in claim 1.

The preferred embodiment according to claim 2 provides a microwave integrated circuit frequency converter which achieves excellent conversion loss and frequency characteristics by short-circuiting the impedance for the image frequency.

Other objects, together with the foregoing, are attained in the embodiments described in the following description and illustrated in the accompanying drawings.

Figs. 1 to 3 are diagrams of a prior art image reflection type of frequency converter;

Fig. 4 is a diagram of a 3-resonator bandstop filter;

Figs. 5 and 6 are diagrams of a microwave integrated circuit frequency converter embodying the present invention;

Fig. 7 is a graph showing a frequency arrangement of a frequency converter; and

Fig. 8 is a plot indicating actually measured conversion losses of the frequency converters shown in Figs. 1 and 5.

### Description of the preferred embodiments

While the microwave integrated circuit frequency converter of the present invention is susceptible of numerous physical embodiments, depending upon the environment and requirements of use, substantial numbers of the herein shown and described embodiments have been made, tested and used, and all have performed in an eminently satisfactory manner.

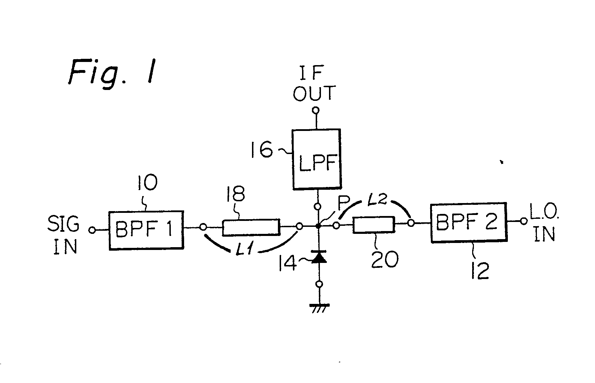

Referring to Fig. 1 of the drawings, a prior art MIC frequency converter is shown. The frequency converter comprises a band-pass filter 10 for a signal frequency (abbreviated as BPF 1 thereinafter), a band-pass filter 12 for a local oscillator frequency (abbreviated as BPF 2 hereinafter), a diode 14 for mixing the signal and local oscillator frequencies to produce an intermediate frequency, a low-pass filter 16 (abbreviated as LPF hereinafter) for reflecting the signal and local oscillator frequencies and passing the intermediate frequency, and transmission lines 18 and 20 each having a predetermined electrical length L1 or L2.

The diode 14 is driven by local oscillator power which is applied thereto via the BPF 2 with a frequency $f_{LO}$. When a signal frequency $f_S$ is fed to the diode 14 via the BPF 1, the diode 14 mixes the frequencies $f_{LO}$ and $f_S$ and outputs frequency components generally expressed as:

$$f=|nf_{LO}\pm mf_S| \qquad \text{Eq. (1)}$$

where n and m may be any integer 0, 1, 2.

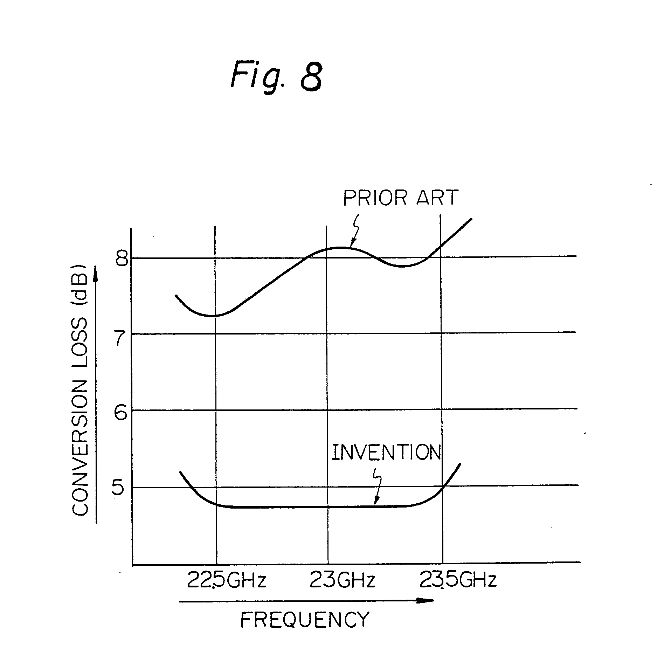

Of these frequency components, those having significant influence on the behavior of the frequency converter are the output signal component $f_{IF}=f_S-f_{LO}$ and the image frequency component $f_{IM}=2f_{LO}-f_S$. This applies not only to a frequency converter for reception but to a frequency converter for transmission, in which the operation is greatly effected by an output signal component $f_S=f_{LO}+f_{IF}$ and an image frequency component $f_{IM}=f_{LO}-f_{IF}$ where $f_{IF}$ is an input intermediate signal frequency. The signal frequency, local oscillator frequency, image frequency and intermediate frequency may be plotted on a frequency domain diagram as indicated in Fig. 7.

To attain an output signal component efficiently from the frequency converter, it is a primary requisite that impedance matching with the diode 14 be set up as seen from each terminal for the local oscillator frequency, signal frequency and intermediate frequency. In the frequency converter shown in Fig. 1, the impedance is open-circuited for the signal frequency and local oscillator frequency and matched with the intermediate frequency when the LPF is seen from the junction P. Therefore, if the electrical length of the transmission line 18 is selected such that the impedance is open-circuited for the local oscillator frequency when the BPF 1 is seen from the junction P, the local oscillator input becomes terminated at the diode 14 resulting in ease of impedance matching. Easy matching is also attainable if the electrical length of the transmission line 20 is selected such that the impedance is open-circuited for the signal frequency $f_s$ when the BPF 2 is seen from the junction P, causing the signal input to terminate at the diode 14. So selecting the electrical lengths of the transmission lines 18 and 20 allows impedance matching to be readily obtained with the signal frequency and local oscillator frequency.

However, concerning a diode of the type driven by local oscillator power and supplied with signal power, desirable conversion loss and frequency characteristics cannot be accomplished unless the produced image frequency is open- or short-circuited as seen from the diode side. The prior art frequency converter shown in Fig. 1 is incapable of permitting the impedance to be open- or short-circuited for the image frequency, because the electrical lengths of the transmission lines 18 and 20 are respectively determined by the matching conditions with the local oscillator frequency and signal frequency. This degrades the conversion loss and frequency characteristics of the frequency converter.

Referring to Fig. 2 of the drawings, another prior art frequency converter as described in US—A—4,211,977 is shown. The frequency converter is provided with bandstop filters 101, 102 and 103 for rejecting a local oscillator frequency, a signal frequency, and an image frequency, respectively. The frequency converter also includes signal and local oscillator input transmission lines 104 and 105, a short-circuited stub 106, a diode 107, and a lowpass filter 108. The electrical length between the bandstop filter 101 and the diode 107 is a quarter wavelength of local oscillator frequency so that the impedance as seen from the junction to the input signal port is open-circuited for the local oscillator frequency. Similarly, the electrical length between the bandstop filter 102 and the diode 107 is a quarter wavelength of the signal frequency.

The prior art frequency converter operates similarly to the converter as shown in Fig. 1 except that the bandstop filters 101 and 102 are used in place of the bandpass filters 10 and 12 and the bandstop filter 103 is used for image frequency rejection. The bandstop filter 103 provides a short-circuit for the image frequency as seen from the diode 107, resulting in an improvement in conversion loss. Generally, in a frequency converter, signal and image frequencies have some bandwidth (for example, 500 MHz bandwidth centered at 6 GHz). The bandstop filters 102 and 103, therefore, must have a bandwidth which is wide enough to attain a superior conversion loss over the signal bandwidth. It follows that, although multi-resonator bandstop filters are required for such an application a multi-resonator configuration is impracticable when it comes to the bandstop filter 103, as will be seen from Fig. 2. Hence, the frequency converter of Fig. 2 cannot be applied except for a narrow bandwidth.

Fig. 3 show another and similar frequency converter in which a bandpass filter 112 is used in place of the bandstop filter 102 of Fig. 2. In this frequency converter, although the bandstop filter 113 may be realized in a multi-resonator configuration (see Fig. 4 for example), the whole circuit will become untolerably large in size. In addition, the length of the input signal is increased to in turn increase the conversion loss.

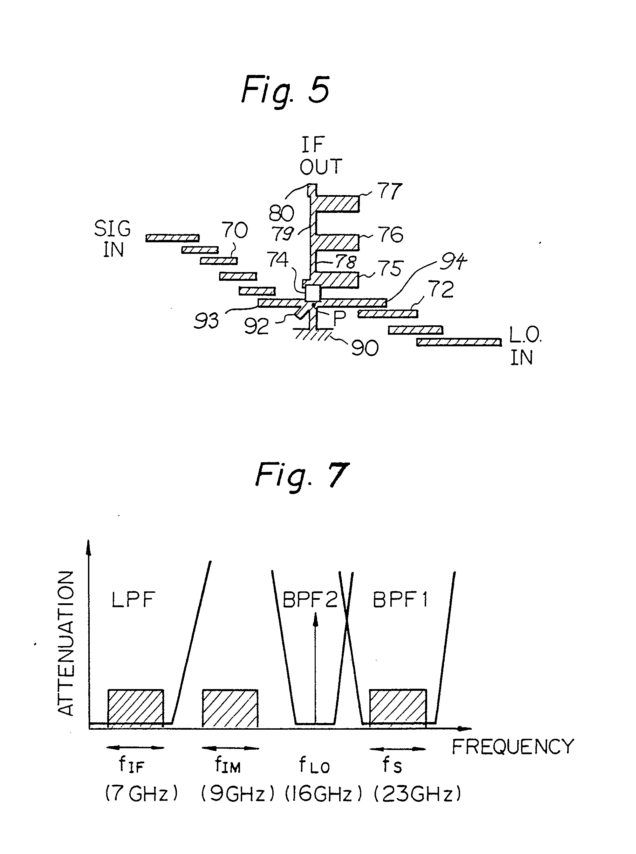

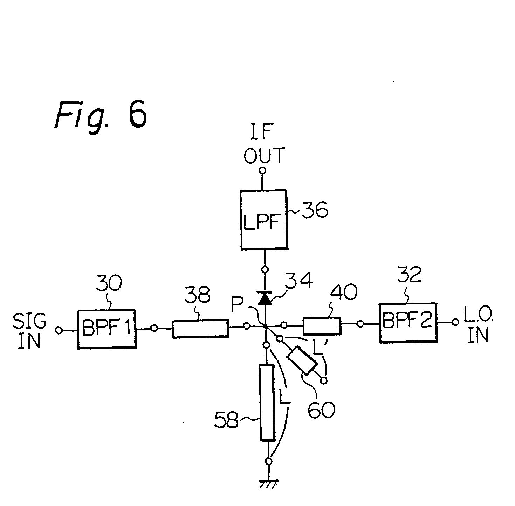

Referring to Fig. 5, a frequency converter of the present invention includes a parallel-coupled bandpass filter 70 for a signal frequency, a parallel-coupled bandpass filter 72 for a local oscillator frequency, a diode 74, a lowpass filter 80, transmission lines 93 and 94 each having a predetermined electrical length, a short-circuited shunt stub 90, and an open-circuited shunt stub 92. A conceptual circuit diagram associated with Fig. 5 is shown in Fig. 6. The electrical length of transmission line 94 (40 in Fig. 6) is one half the wavelength of a signal frequency from the open end of the bandpass filter 72, so that the impedance as seen from the junction P is open-circuited for a signal frequency. Likewise, the electrical length of the transmission line 93 (38 in Fig. 6) is one half the wavelength of a local oscillator frequency. The sum of electrical length of the shunt stubs 90 L (58 in Fig. 6) and 92 L' (60 in Fig. 6) satisfies the following opening condition:

$$L+L'=(2h-1)/4\ \lambda_s$$

n being an integer and $\lambda_s$ being the wavelength of the signal frequency. Therefore, the impedance of the combination of two parallel stub lines as seen from the junction are approximately open-circuited for signal and local oscillator frequencies. The lowpass filter 80 (36 in Fig. 6) provides a short-circuit impedance as seen from the diode for signal frequency, local oscillator frequency, and image frequency. The lowpass filter comprises low impedance shunt stub (75—77) and high impedance connecting lines (78, 79). In the circuit configuration explained above, the signal input port and the local oscillator input port are effectively terminated by the diode for respective frequencies and good impedance matching is achieved.

Fig. 8 shows curves demonstrating the superiority in conversion loss of the construction shown in Fig. 5 to the construction shown in Fig. 1. It will be apparent from the curves that the present invention is far advantageous over the prior art both in converion loss and frequency characteristics.

In summary, it will be seen that the present invention provides a microwave integrated circuit frequency converter which has improved conversion loss and frequency characteristics due to its matching with a signal frequency and a local oscillator frequency. This is achievable merely by locating a suitable length of series transmission line and a suitable length of parallel stub line of a combination of a parallel stub line with one end short-circuited and a parallel stub line with one end opened, at a point P where a band-pass filter for a signal and a band-pass filter for a local oscillator signal are connected together.

The principle of the present invention may be applied to a frequency converter for transmission instead of reception.

## Claims

1. A microwave integrated circuit frequency converter comprising:

a) first bandpass filter means (30) having an input connected to receive a signal frequency;

b) second bandpass filter means (32) having an input connected to receive a local oscillator frequency;

c) first transmission line means (38) connecting an output of the first bandpass filter means (30) to a junction (P);

d) second transmission line means (40) connecting an output of the second bandpass filter means (32) to the junction (P);

e) lowpass filter means (36) for passing an intermediate frequency and reflecting the signal and local oscillator frequencies and an image frequency;

f) diode means (34) coupled between the junction (P) and an input of the lowpass filter means (36);

g) first parallel stub line means (58) having one end short-circuited and the other end connected to the junction (P); characterized in that

h) second parallel stub line means (60) are provided having one end open-circuited and the other end connected to the junction (P);

i) the electrical lengths of the first and second transmission line means (38 and 40) from the open end of the filter means are one half of the wavelengths of the local oscillator frequency and the signal frequency respectively, so that an impedance seen from the junction (p) is open-circuited to the local oscillator frequency and the signal frequency; and

j) the length L of the first parallel stub line means (58) and the length L' of the second parallel stub line means (60) are determined to satisfy the following opening condition:

$$L+L'=(2n-1)/4 \cdot \lambda_s$$

n being an integer and $\lambda_s$ being the wavelength of the signal frequency.

2. A converter as claimed in claim 1 characterized in that the length of the first stub line means (58) is an odd multiple of half of the wavelength of the image frequency.

## Patentansprüche

1. Integrierter Mikrowellen-Frequenzumsetzer mit:

a) einer ersten Bandpaßfiltereinrichtung (30) mit einem Eingang, um eine Signalfrequenz zu empfangen;

b) einer zweiten Bandpaßfiltereinrichtung (32) mit einem Eingang, um eine Überlagererfrequenz zu empfangen;

c) einer ersten Übertragungsleitungseinrichtung (38), die einen Ausgang der ersten Bandpaßfiltereinrichtung (30) mit der Zusammenführung (P) verbindet,

d) einer zweiten Übertragungsleitungseinrichtung (40), die einen Ausgang der zweiten Bandpaßfiltereinrichtung (32) mit der Zusammenführung (P) verbindet;

e) einer Tiefpaßfiltereinrichtung (36), um eine Zwischenfrequenz hindurchzulassen und das Signal, die Überlagererfrequenz und ein Spiegelfrequenz zu reflektieren;

f) einer Diodeneinrichtung (34), die eine Kopplung zwischen der Zusammenführung (P) und einem Eingang der Tiefpaßfiltereinrichtung (36) darstellt;

g) einer ersten parallelen Abstimmleitungseinrichtung (58), deren eines Ende Kurzgeschlossen und deren anderes Ende mit der Zusammenführung (P) verbunden ist; dadurch gekennzeichnet, daß

h) eine zweite parallele Abstimmleitungseinrichtung (60) vorgesehen ist, deren eines Ende offen und deren anderes Ende mit der Zusammenführung (P) verbunden ist;

i) die elektrischen Längen der ersten und zweiten Übertragungsleitungseinrichtungen (38 und 40), ausgehend vom offenen Ende der Filtereinrichtungen, die Hälfte der Wellenlängen der örtlichen Überlagererfrequenz und der Signalfrequenz sind, so daß eine Impedanz, von der Zusammenführung (P) gesehen, zur Überlagererfrequenz und zur Signalfrequenz offen ist; und

j) die Länge L der ersten parallelen Abstimmleitungseinrichtung (58) und die Länge L' der zweiten parallelen Abstimmleitungseinrichtung (60) so vorbestimmt sind, daß sie der Anfangsbedingung

$$L+L'=(2n-1)/4 \cdot \lambda_s$$

wobei n ganzzahlig und $\lambda_s$ die Wellenlänge der Signalfrequenz ist, genügt.

2. Umsetzer nach Anspruch 1, dadurch gekennzeichnet, daß die Länge der ersten Abstimmleitungseinrichtung (58) ein ungeradzahliges Vielfaches der halben Wellenlänge der Spiegelfrequenz ist.

## Revendications

1. Convertisseur de fréquence à circuit intégré pour micro-onde comprenant:

a) un premier moyen de filtre passe-bande (30) ayant une entrée connectée pour recevoir une fréquence de signal;

b) un second moyen de filtre passe-bande (32) ayant une entrée connectée pour recevoir une fréquence d'oscillateur local;

c) un premier moyen de ligne de transmission (38) connectant une sortie du premier moyen de filtre passe-bande (30) à une jonction (P);

d) un second moyen de ligne de transmission (40) connectant une sortie du second moyen de filtre passe-bande (32) à la jonction (P);

e) un moyen de filtre passe-bas (36) pour envoyer une fréquence intermédiaire et réfléchir les fréquences de signal et d'oscillateur local et une fréquence-image;

f) un moyen de diode (34) couplé entre la jonction (P) et une entrée du moyen de filtre passe-bas (36);

g) un premier moyen de ligne d'adaptateur en parallèle (58) ayant une extrémité court-circuitée et l'autre extrémité connectée à la jonction (P); caractérisé en ce que

h) un second moyen de ligne d'adaptateur en parallèle (60) sont fournies comportant une extrémité en circuit ouvert et l'autre extrémité connectée à la jonction (P);

i) les longueurs électriques des premier et second moyens de ligne de transmission (38 et 40) à partir de l'extrémité ouverte du moyen de filtre sont la moitié des longueurs d'onde de la fréquence d'oscillateur local et de la fréquence de signal, respectivement, de sorte qu'une impédance vue depuis la jonction (P) est en circuit ouvert vers la fréquence d'oscillateur local et la fréquence de signal, et

j) la longueur L du premier moyen de ligne d'adaptateur en parallèle (58) et la longueur L' du second moyen de ligne d'adaptateur en parallèle (60) sont déterminées pour satisfaire la condition d'ouverture suivante:

$$L+L'=(2n-1)/4\lambda_s$$

n étant un nombre entier et $\lambda_s$ étant la longueur d'onde de la fréquence de signal.

2. Convertisseur selon la revendication 1, caractérisé en ce que la longueur du premier moyen de ligne d'adaptateur (58) est un multiple impair de la moitié de la longueur d'onde de la fréquence-image.

*Fig. 1*

IF
OUT

16 ~ LPF

10

18

SIG o— BPF 1
IN

P  *L2*

L1

14 ~

20  BPF 2  o L.O.
IN

12

## Fig. 2

IF OUT

108

101

102

~107

SIG IN

L.O. IN

104

106

105

103

## Fig. 3

L.O. IN

112

113

117

118

IF OUT

111

116

SIG IN

## Fig. 4

122

124

121

123

# Fig. 5

# Fig. 7

*Fig.* 6

## Fig. 8